(19) **Europäisches Patentamt**
**European Patent Office**
**Office européen des brevets**

(11) **EP 4 560 243 A1**

(12) **EUROPEAN PATENT APPLICATION**
published in accordance with Art. 153(4) EPC

(43) Date of publication:
**28.05.2025 Bulletin 2025/22**

(21) Application number: **23843031.8**

(22) Date of filing: **20.07.2023**

(51) International Patent Classification (IPC):
**F28D 15/02** (2006.01)  **B21D 39/00** (2006.01)
**H01L 23/427** (2006.01)  **H05K 7/20** (2006.01)

(52) Cooperative Patent Classification (CPC):
**B21D 39/00; F28D 15/02; H01L 23/427; H05K 7/20**

(86) International application number:
**PCT/JP2023/026555**

(87) International publication number:
**WO 2024/019108 (25.01.2024 Gazette 2024/04)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.07.2022 JP 2022117281**

(71) Applicant: **Kyocera Corporation
Kyoto-shi, Kyoto 612-8501 (JP)**

(72) Inventor: **KONISHI Yoshitada
Kyoto-shi, Kyoto 612-8501 (JP)**

(74) Representative: **Viering, Jentschura & Partner
mbB
Patent- und Rechtsanwälte
Am Brauhaus 8
01099 Dresden (DE)**

(54) **HEAT-EMITTING SUBSTRATE AND VAPOR CHAMBER**

(57) A heat dissipation substrate includes a housing and a seal body. The housing includes an internal space. The seal body seals the internal space. The housing includes a through-hole and an internal bottom surface. The through-hole communicates with the internal space. The seal body includes a first portion and a second portion. The first portion is positioned at the internal space, and the second portion is positioned at the thorough-hole. The first portion contacts the internal bottom surface. A maximum width of the first portion is larger than a minimum width of the through-hole in a vertical section.

## FIG. 1A

## Description

TECHNICAL FIELD

The present disclosure relates to a heat dissipation substrate and a vapor chamber.

BACKGROUND OF INVENTION

International Publication No. 2008/012960 describes a heat pipe including a sealing member made of a copper-based metal and plugging a refrigerant filling hole and an air exhaust hole.

SUMMARY

SOLUTION TO PROBLEM

In the present disclosure, a heat dissipation substrate includes a housing and a seal body. The housing includes an internal space. The seal body seals the internal space. The housing includes a through-hole and an internal bottom surface. The through-hole communicates with the internal space. The seal body includes a first portion and a second portion. The first portion is positioned at the internal space, and the second portion is positioned at the thorough-hole. The first portion contacts the internal bottom surface. A maximum width of the first portion is larger than a minimum width of the through-hole in a vertical section.

In the present disclosure, a vapor chamber includes the heat dissipation substrate described above and liquid-phase fluid. The liquid-phase fluid is positioned at the internal space.

BRIEF DESCRIPTION OF THE DRAWINGS

FIG. 1A is a vertical sectional view illustrating a heat dissipation substrate and a vapor chamber according to Embodiment 1 of the present disclosure.
FIG. 1B is a vertical sectional view illustrating the heat dissipation substrate and the vapor chamber according to Embodiment 1 of the present disclosure.
FIG. 1C is a perspective view illustrating the heat dissipation substrate and the vapor chamber according to Embodiment 1 of the present disclosure.
FIG. 2A is a vertical sectional view illustrating surroundings of a seal body.
FIG. 2B is a sectional view taken along line B-B in FIG. 2A.
FIG. 3A is a transverse sectional view illustrating a heat dissipation substrate in Embodiment 2.
FIG. 3B is a sectional view taken along line B-B in FIG. 3A.
FIG. 4A is a vertical sectional view of a heat dissipation substrate in Embodiment 3.
FIG. 4B is an enlarged view illustrating a portion C1 in FIG. 4A.
FIG. 5A is a vertical sectional view illustrating a heat dissipation substrate in Embodiment 4.
FIG. 5B is a vertical sectional view illustrating a heat dissipation substrate in Embodiment 5.
FIG. 5C is a vertical sectional view illustrating a heat dissipation substrate in Embodiment 6.
FIG. 6A is a view describing a shape of a seal body in Embodiments 1 to 3.
FIG. 6B is a view describing a shape of a seal body in Embodiments 4 to 6.
FIG. 7 is a vertical sectional view illustrating a heat dissipation substrate in Embodiment 7.
FIG. 8A is a vertical sectional view illustrating a heat dissipation substrate in Embodiment 8.
FIG. 8B is an enlarged view illustrating a portion C2 in FIG. 8A.
FIG. 9A is a vertical sectional view illustrating an example in which an element is mounted on a heat dissipation substrate in an embodiment.
FIG. 9B is a perspective view illustrating an example in which an element is mounted on a heat dissipation substrate in an embodiment.

DESCRIPTION OF EMBODIMENTS

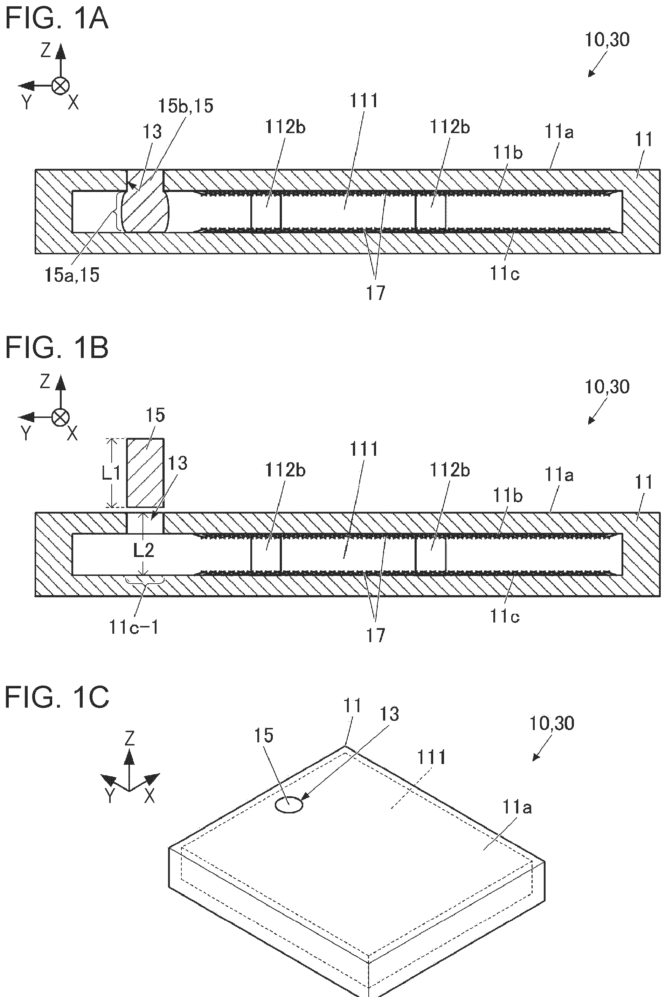

Hereinafter, each embodiment of the present disclosure is described in detail with reference to the drawings. Below, description is made while assuming that a direction along an X-Y plane in FIG. 1 is a horizontal direction, and a Z-direction is an upper direction. However, the respective directions do not necessarily match directions during use of a heat dissipation substrate 10 or a vapor chamber 30.

(Embodiment 1)

FIGs. 1A and 1B are vertical sectional views illustrating a heat dissipation substrate and a vapor chamber according to Embodiment 1 of the present disclosure. FIG. 1C is a perspective view illustrating the heat dissipation substrate and the vapor chamber according to Embodiment 1. FIG. 1B illustrates a configuration before sealing of an internal space 111.

In Embodiment 1, the heat dissipation substrate 10 includes a housing 11 with the internal space 111 and a seal body 15 that seals the internal space 111. The housing 11 may include a through-hole 13 communicating with the internal space 111, an internal top surface 11b, and an internal bottom surface 11c. The seal body 15 may plug the through-hole 13 to seal the internal space 111.

As illustrated in FIG. 1C, the housing 11 may have a flat-plate-like shape (specifically, a flat-plate-like shape with a horizontal dimension larger than a vertical dimension). The through-hole 13 opens at a first surface 11a that is an upper surface of the housing 11 and may have a planar shape. The internal space 111 may be a space expanding in the horizontal direction (specifically, a space with a horizontal dimension larger than a vertical dimension).

The internal space 111 may include one or more pillars 112b positioned from the internal bottom surface 11c to the internal top surface 11b. The pillars 112b may support the housing 11 from an inner side of the internal space 111 so that the internal space 111 does not collapse or expand.

The housing 11 and the seal body 15 may be made of metal. A main constituent of the metal may be copper, aluminum, titanium, nickel, stainless steel, or an iron-based alloy (for example, Kovar (FeNiCo)). The main constituent means a constituent that accounts for 80 mass% or more. The housing 11 and the seal body 15 may be made of metals with the same main constituent. The housing 11 and the seal body 15 may be made of metals with the same composition. The composition being the same includes not only being strictly the same, but also being the same except for an error (the error is within a range of tolerance).

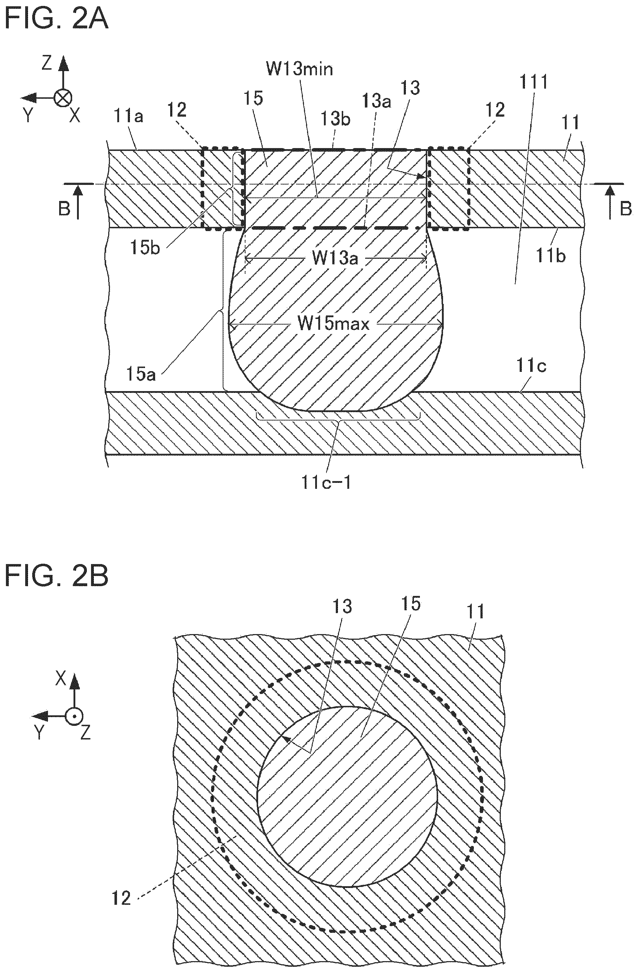

The material for the housing 11 described above is a material for at least an internal wall part 12 (see FIG. 2) of the through-hole 13, and a portion of the housing 11 except for the internal wall part 12 may be made of a different material. The internal wall part 12 means a portion surrounding the through-hole 13 and facing the through-hole 13 in the housing 11. The internal wall part 12 may mean a portion with a thickness from the through-hole 13 within a range from 1/5 to 1/2 a diameter of the through-hole 13.

The heat dissipation substrate 10 may include a void structure 17 with a void. The void structure 17 may be positioned inside the internal space 111. More specifically, the void structure 17 may be positioned in contact with the internal surface (for example, the internal top surface 11b and/or the internal bottom surface 11c) of the internal space 111, or may be integrated with the internal surface. The void structure 17 may function as a wick that can hold and transport liquid-phase fluid by surface tension. The void structure 17 may be a set of fibrous bodies, sintered bodies, porous bodies, or needle-like bodies, or a net-like structure. Alternatively, the void structure 17 may be a structure including a plurality of layered plates each including a plurality of holes (specifically, pores). The void structure 17 may be made of a material, such as metal or ceramics.

<Vapor Chamber>

In this embodiment, the vapor chamber 30 includes the heat dissipation substrate 10 and liquid-phase fluid positioned at the internal space 111. The internal space 111 may be depressurized. The liquid-phase fluid may employ water, acetone, methanol, ammonia, or the like. In this configuration, when heat is applied to any part of the heat dissipation substrate 10, phase transition (that is, vaporization and condensation) of liquid-phase fluid, and reflux of liquid-phase fluid and gas-phase fluid obtained by vaporization of liquid-phase fluid inside the internal space 111 allow the above-described heat to dissipate promptly. Upon application of heat to the heat dissipation substrate 10, liquid-phase fluid may vaporize to increase internal pressure of the internal space 111 to be higher than pressure outside of the housing 11. Heat dissipation substrates 10A to 10G in Embodiments 2 to 8 described later can also be configured as described above to configure the vapor chamber of this embodiment.

<Details of Seal Part>

FIG. 2A is a vertical sectional view illustrating surroundings of a seal body. FIG. 2B is a sectional view taken along line B-B in FIG. 2A.

As illustrated in FIG. 2B, a transverse cross section of the through-hole 13 may have a circular shape. The seal body 15 may have a cylindrical shape conforming to the shape of the through-hole 13. Alternatively, the transverse cross section of the through-hole 13 may have various shapes including an oval shape, an elliptical shape, a polygonal shape, and a shape with a linear side and a curved side. The seal body 15 may have a shape corresponding to the through-hole 13.

Below, in the through-hole 13, an opening positioned at a boundary to the internal space 111 is referred to as a first opening part 13a, and an opening at an outer side is referred to as a second opening part 13b (see FIG. 2A). In the housing 11, the portion surrounding the through-hole 13 is referred to as the internal wall part 12. In FIG. 2A, the first opening part 13a and the second opening part 13b are indicated by thick one-dot lines. In FIGs. 2A and 2B, the internal wall part 12 is indicated to be surrounded by thick dotted lines.

The through-hole 13 may extend linearly from the first opening part 13a to the second opening part 13b.

As illustrated in FIG. 2A, the seal body 15 may include a first portion 15a positioned inside the internal space 111 and a second portion 15b positioned at the through-hole 13. The first portion 15a may be in contact with a first internal bottom surface 11c-1 of the internal space 111. The first internal bottom surface 11c-1 is a portion of the internal bottom surface 11c of the internal space 111 and corresponds to a portion overlapping the through-hole 13 when seen through along the through-hole 13.

The second portion 15b of the seal body 15 may be in close contact with the internal wall part 12 of the through-hole 13 while applying pressure on the internal wall part 12. Alternatively, a bonding material such as a brazing material may fill a gap between the second portion 15b and the internal wall part 12.

In a vertical section, a maximum width W15max of the first portion 15a may be larger than a minimum width W13min of the through-hole 13 (that is, W15max > W13min). The maximum width W15max of the first portion 15a may be larger than a width W13a of the first opening part 13a (that is, W15max > W13a). As described above, the first opening part 13a means the opening positioned at the boundary to the internal space 111 in the through-hole 13. The width W13a of the first opening part 13a may mean a length of a line segment connecting one end to the other end of the first opening part 13a in the vertical section. The vertical section may mean a plan section passing the center of gravity of the first opening part 13a and the center of gravity of the second opening part 13b. A relationship between the maximum width W15max and the minimum width W13min may be a relationship that is established in a vertical section in any direction, or a relationship that is established except for in a vertical section in some directions.

The relationship between the minimum width W13min and the maximum width W15max described above reduces a possibility of the seal body 15 coming out from the through-hole 13 and allows the sealed state to be maintained easily even when internal pressure of the internal space 111 increases. The relationship between the width W13a and maximum width W15max further reduces the possibility of the seal body 15 coming out from the through-hole 13 and allows the sealed state to be maintained more easily even when internal pressure of the internal space 111 increases.

As also described earlier, the first portion 15a may be in contact with the first internal bottom surface 11c-1. This configuration makes a tip-end surface of the first portion 15a less likely to be exposed to internal pressure of the internal space 111 even when the internal pressure of the internal space 111 increases. Therefore, force can be less likely to act on the seal body 15 in a direction to push out the seal body 15 by the increased internal pressure. Thereby, the seal body 15 has less possibility to be displaced in the direction to come out from the through-hole 13, and maintaining of the sealed state of the internal space 111 becomes easy.

The first portion 15a being in contact with the first internal bottom surface 11c-1 increases rigidity of a portion of the housing 11 at a vicinity of the seal body 15. Therefore, when a terminal of an element or a conductor wire is ultrasonic-bonded to the first surface 11a, bonding becomes easy.

<Sealing Process>

As illustrated in FIG. 1B, a length L1 of the seal body 15 before sealing may be longer than a length L2 from the outer-side opening part of the through-hole 13 (specifically, the second opening part 13b, see FIG. 2A) to the first internal bottom surface 11c-1. The seal body 15 before sealing may have a thickness that allows the seal body 15 to pass through the through-hole 13.

The sealing process may include a step of bringing the seal body 15 to pass through the through-hole 13 until one end of the seal body 15 contacts the first internal bottom surface 11c-1. The sealing process may also include a step of further pushing-in the seal body 15. The step of further pushing-in deforms the first portion 15a of the seal body 15 to have an extended diameter as illustrated in FIG. 2A, and makes the maximum width W15max of the first portion 15a to be larger than the minimum width W13min of the through-hole 13. During the deformation, an increase in a diameter of the second portion 15b of the seal body 15, or filling of a bonding material such as a brazing material around the second portion 15b causes the through-hole 13 to be plugged, thus sealing the internal space 111. Before or after the seal body 15 being passed through the through-hole 13, the seal body 15 may be cut or polished in such a manner that the first surface 11a and an end surface of the seal body 15 become flush with one another.

Before the sealing process described above, liquid-phase fluid may be introduced into the internal space 111 through the through-hole 13. The sealing process may be performed in a depressurized space. This process can seal the internal space 111 in a state in which the internal space 111 includes liquid-phase fluid and is depressurized.

With the sealing structure of the heat dissipation substrate 10 achieved by the sealing process described above, the through-hole 13, particularly a portion of the through-hole 13 at the first surface 11a side, is less likely to deform, and thereby the first surface 11a can have improved flatness also around the seal part.

(Embodiment 2)

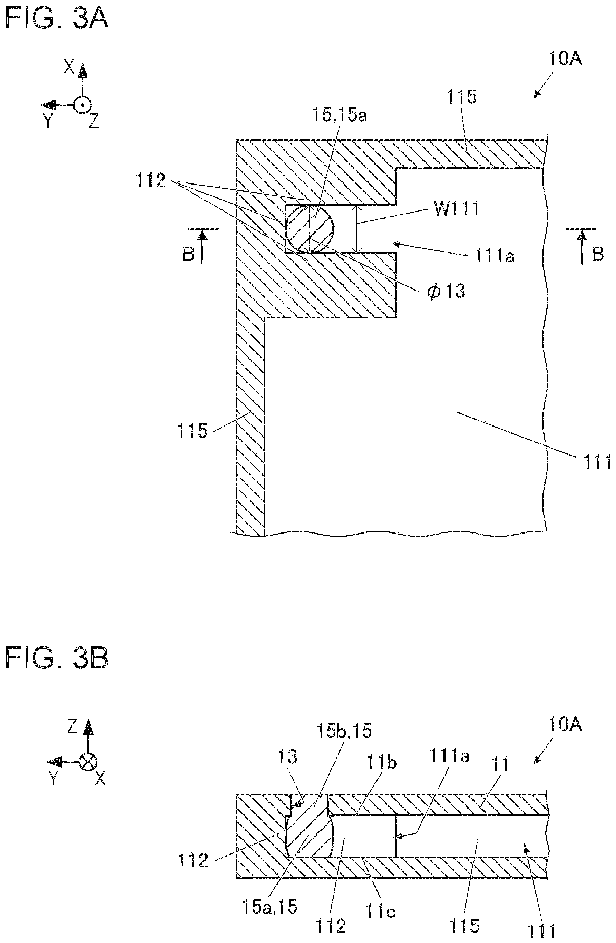

FIG. 3A is a transverse sectional view illustrating a heat dissipation substrate in Embodiment 2. FIG. 3B is a sectional view taken along line B-B in FIG. 3A. In Embodiment 2, a heat dissipation substrate 10A may be the same as and/or similar to that in Embodiment 1, except for difference in a structure at a vicinity of the seal body 15 in the internal space 111.

In Embodiment 2, the heat dissipation substrate 10A may include a support body 112 of the internal space 111 at a side of the seal body 15. The support body 112 is a structure supporting the housing 11 from the inner side of the internal space 111 so that the internal space 111 does not collapse or expand. The support body 112 may be a side wall of the internal space 111 or may be a pillar positioned from the internal bottom surface 11c to the internal top surface 11b. In FIG. 3A, a side wall that is thicker than another portion is adopted as the support body 112.

The support body 112 may be positioned in contact with the first portion 15a of the seal body 15. The support body 112 and the seal body 15 may entirely be in contact with one another from the internal bottom surface 11c to the internal top surface 11b, partially be in contact with one another, or entirely be in contact with one another with a slight gap therebetween.

As illustrated in FIG. 3A, the support body 112 may be positioned on three sides in the horizontal direction when seen from the seal body 15, or may be positioned on two or one side in the horizontal direction. The one side, two sides, and three sides respectively mean one direction, two directions, and three directions when the entire circumference is equally divided into four in the horizontal direction.

The support body 112 at the side of the seal body 15 may be thicker than a side wall 115 of another region.

Providing of the support body 112 can further reduce deformation around the through-hole 13 when the seal body 15 plugs the through-hole 13. The thick support body 112 can further reduce the above-described deformation. The thick support body 112 allows the through-hole 13 to be disposed in such a manner as not to be excessively close to an end of the first surface 11a, and provides advantage that the through-hole 13 can have an improved degree of freedom in placement in a design phase.

As illustrated in FIG. 3A, in a configuration in which the support body 112 is positioned on three sides of the seal body 15, a passage 111a communicating with a wide portion of the internal space 111 is placed on the remaining one side. A width W111 of the passage 111a may be larger than, the same as, or smaller than a diameter φ13 of the through-hole 13. The smaller the width W111 of the passage 111a, the larger effect of reducing deformation of the housing 11 at the vicinity of the seal part is obtained. When the through-hole 13 does not have a cylindrical shape, the above-described diameter may be rephrased as a minimum width. Since liquid-phase fluid is less likely to circulate at the passage 111a, the passage 111a may be positioned at a portion where a decrease in a heat dissipation effect is acceptable (for example, at a vicinity of an outer circumference of the first surface 11a in plan view).

(Embodiment 3)

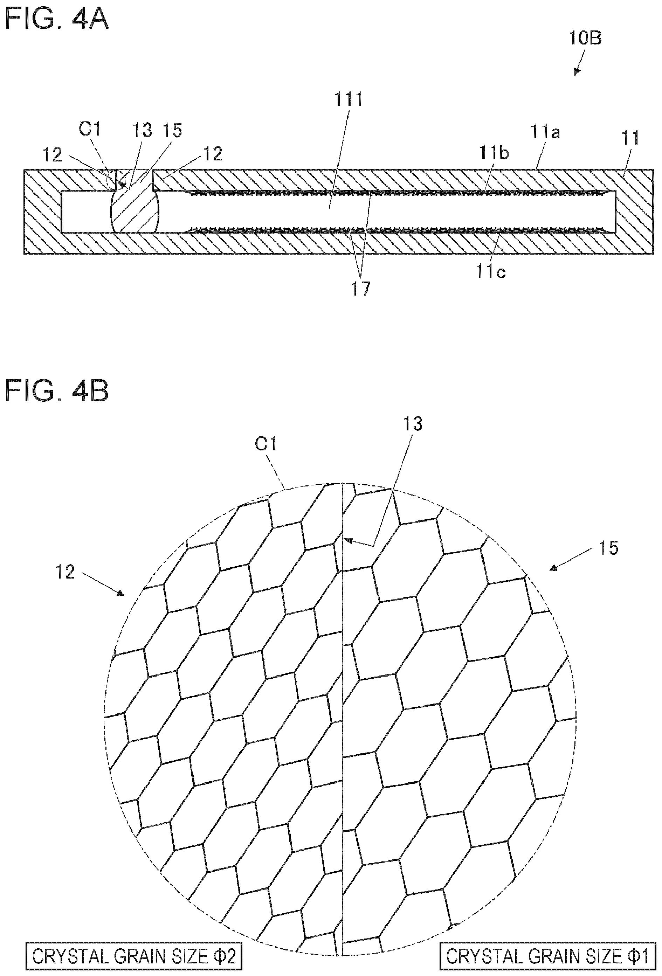

FIG. 4A is a vertical sectional view of a heat dissipation substrate in Embodiment 3. FIG. 4B is an enlarged view of a portion C1 in FIG. 4A. In Embodiment 3, a heat dissipation substrate 10B may include components the same as and/or similar to those in Embodiments 1 and 2, except for difference in a crystal grain size of the internal wall part 12 of the through-hole 13 and a crystal grain size of the seal body 15.

A crystal grain size φ1 of the seal body 15 and a crystal grain size φ2 of the internal wall part 12 may satisfy the following condition (1). That is, the crystal grain size φ1 of the seal body 15 may be equivalent to or larger than the crystal grain size φ2 of the internal wall part 12.

$$\varphi1 > 0.8 \times \varphi2 \dots (1)$$

The seal body 15 and the internal wall part 12 may be made of metals with the same main constituent, or made of metals with the same composition (for example, copper).

The crystal grain sizes φ1 and φ2 may satisfy the following condition (2), and may further satisfy the following condition (3).

$$\varphi1 \geq \varphi2 \dots (2)$$

$$\varphi1 > \varphi2 \dots (3)$$

Generally, with regard to a main constituent metal or metals with the same composition, the larger the crystal grain size, the more easily deformation occurs upon stress application. Therefore, satisfying the condition (1) described above allows an effect of deforming the seal body 15 to be obtained while further reducing deformation around the through-hole 13 of the housing 11 when the seal body 15 plugs the through-hole 13, and can improve flatness around the seal part of the housing 11 at the external-surface side. Furthermore, satisfying the conditions (2) and (3) described above allows the above-described effect to be further obtained, and can further improve flatness around the seal part.

The crystal grain size described above means an average value of the crystal grain size and is measurable in the following manner. That is, a sectional image of a portion concerned is prepared, a line segment with a predetermined length is drawn on the sectional image, and the number of crystal grains overlapping the line segment is counted. The number of crystal gains overlapping an end of the line segment is counted as 1/2. Then, the length of the line segment (specifically, a length obtained through division by a magnification of the sectional image) is divided by the counted number of crystal grains. Therefore, the crystal grain size of a set of samples is obtained. Further, crystal grain sizes of a plurality of sets of samples are measured while changing the direction and position of the line segment, and an average value of the calculated values is set as the crystal grain size of the measurement target.

The crystal grain size of the internal wall part 12 and the crystal grain size of the seal body 15 are adjustable to be larger or smaller through application of heat treatment. Therefore, by application of heat treatment to the seal body 15, the seal body 15 with the crystal grain size that satisfies the conditions (1) to (3) described above can be produced. The heat treatment is equivalent to heat treatment that is applied during producing of the housing 11 before sealing, or is heat treatment with a predetermined difference from the heat treatment that is applied during producing of the housing 11 before sealing.

Note that the housing 11 may have substantially the same crystal grain size at the internal wall part 12 and any other portion.

(Embodiment 4)

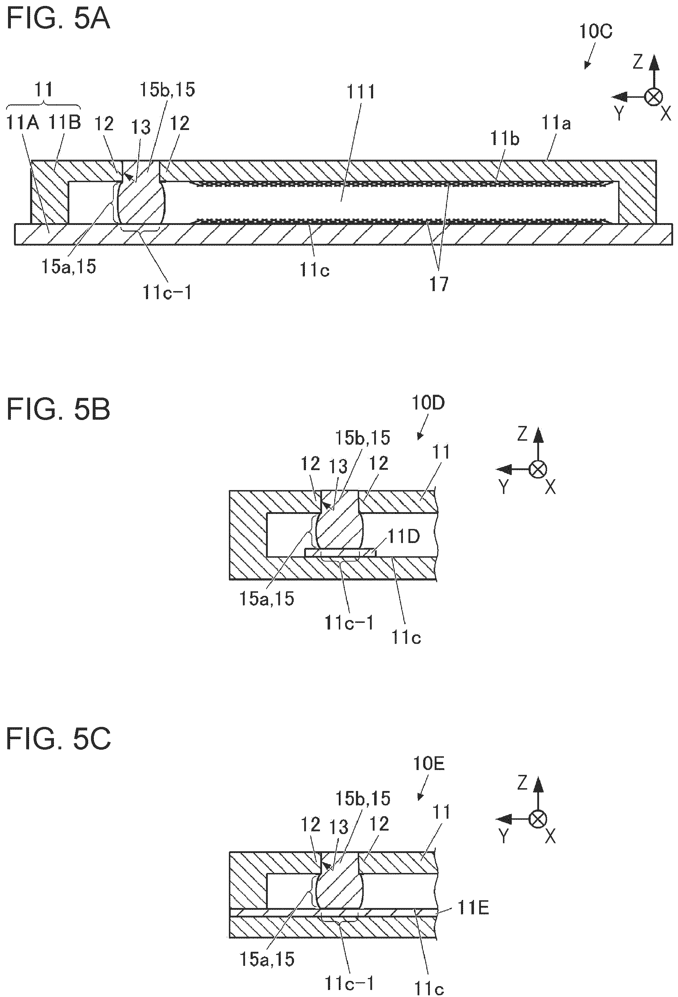

FIGs. 5A to 5C are vertical sectional views respectively illustrating heat dissipation substrates in Embodiments 4, 5, and 6. In Embodiments 4 to 6, heat dissipation substrates 10C to 10E may be the same as and/or similar to those in Embodiments 1 to 3, except for difference in a characteristic of the first internal bottom surface 11c-1 of the internal space 111. The first internal bottom surface 11c-1 contacts the first portion 15a of the seal body 15.

In Embodiments 4 to 6, a Young's modulus of the first internal bottom surface 11c-1 may be larger than a Young's modulus of the seal body 15. Further, the Young's modulus of the first internal bottom surface 11c-1 may be larger than a Young's modulus of the internal wall part 12 of the through-hole 13. The first internal bottom surface 11c-1 means the portion that contacts the first portion 15a of the seal body 15, in the internal bottom surface 11c of the internal space 111. The Young's modulus may mean a value measured by the nanoindentation technique in accordance with the international standard ISO 14577.

Such a configuration can efficiently cause deformation of the first portion 15a of the seal body 15 to expand in the horizontal direction when the seal body 15 plugs the through-hole 13. Therefore, as compared with a case in which the Young's modulus of the first internal bottom surface 11c-1 is not high, the first portion 15a of the seal body 15 can be pressed and expanded with small energy. Thereby, energy applied from the seal body 15 to the through-hole 13 can be reduced, resulting in a reduction in deformation around the through-hole 13. Accordingly, flatness around the seal part of the housing 11 at the external-surface side can improve.

To realize the Young's modulus relationship described above, in Embodiments 4 to 6, the heat dissipation substrates 10C to 10E may be configured as follows. That is, in Embodiment 4 illustrated in FIG. 5A, the heat dissipation substrate 10C may include the housing 11 including a base part 11A and an upper structure 11B bonded to the base part 11A. The base part 11A may be made of a material different from the material for the seal body 15.

Specifically, the upper structure 11B and the seal body 15 may be made of a metal such as copper, and the base part 11A may be made of a ceramic. The ceramic may employ a material including, as a main constituent, silicon nitride ($Si_3N_4$), silicon carbide (SiC), mullite or aluminum nitride (AlN), aluminum oxide ($Al_2O_3$), or the like.

The base part 11A and the upper structure 11B may be bonded to one another with a bonding material such as a brazing material interposed therebetween. The internal space 111 may be positioned between the base part 11A and the upper structure 11B, and the through-hole 13 may be positioned at the upper structure 11B. An upper surface of the base part 11A may include the first internal bottom surface 11c-1.

In Embodiment 5 illustrated in FIG. 5B, the heat dissipation substrate 10D may include, at a portion overlapping the first internal bottom surface 11c-1, a plate-like or filmlike member 11D made of a material different from a material for another portion of the housing 11. The member 11D may be made of a ceramic and bonded to the internal bottom surface 11c of the housing 11 with a bonding material such as a brazing material interposed therebetween. The ceramic may include, as a main constituent, silicon nitride ($Si_3N_4$), silicon carbide (SiC), mullite or aluminum nitride (AlN), aluminum oxide ($Al_2O_3$), or the like.

In Embodiment 6 illustrated in FIG. 5C, the heat dissipation substrate 10E may include the housing 11 with a bottom portion including a multilayer structure. A topmost layer (that is, a layer exposed as the internal bottom surface 11c) 11E of the bottom portion may be made of a material different from a material for another portion of the housing 11. The topmost portion 11E may be made of a ceramic. The ceramic may include, as a main constituent, silicon nitride ($Si_3N_4$), silicon carbide (SiC), mullite or aluminum nitride (AlN), aluminum oxide ($Al_2O_3$), or the like.

In Embodiments 4 to 6 described above, the configurations of the heat dissipation substrates 10C to 10E can realize the Young's modulus relationship described above.

<Young's Modulus Relationship and Seal Body Shape>

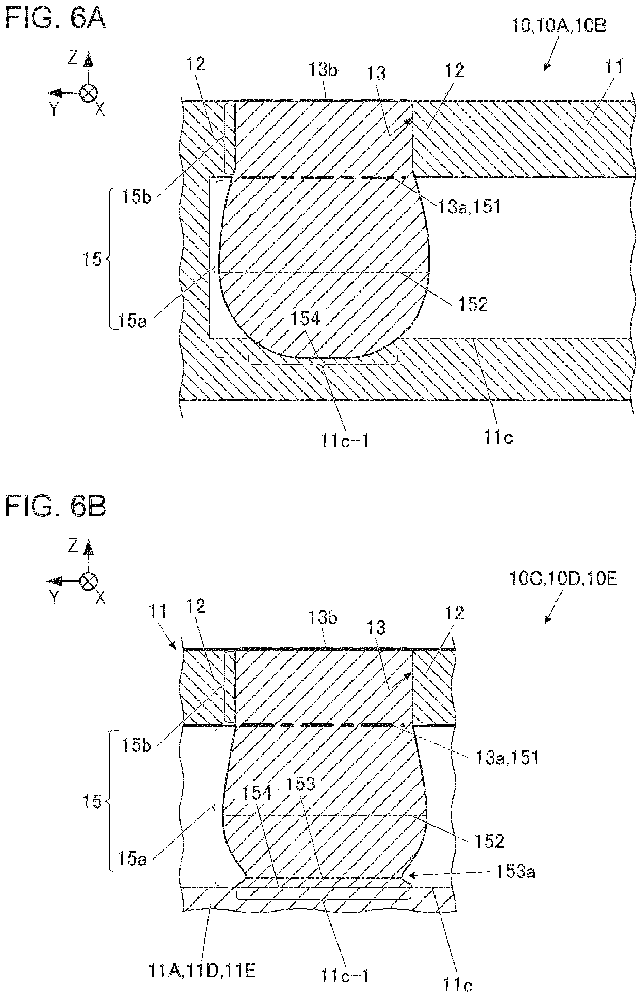

Here, in Embodiments 1 to 6, the shape of the seal body 15 described above is described in detail. FIG. 6A is a view describing the shape of the seal body in Embodiments 1 to 3. FIG. 6B is a view describing the shape of the seal body in Embodiments 4 to 6. In Embodiments 1 to 3, the Young's modulus of the first internal bottom surface 11c-1 is equivalent to the Young's moduli of the seal body 15 and the internal wall part 12. In Embodiments 4 to 6, the Young's modulus of the first internal bottom surface 11c-1 is larger than the Young's moduli of the seal body 15 and the internal wall part 12. As described above, in the through-hole 13, the opening positioned at the boundary to the internal space 111 is referred to as the first opening part 13a, and the opening at the outer side is referred to as the second opening part 13b.

As illustrated in FIG. 6A, in Embodiments 1 to 3, the first portion 15a of the seal body 15 includes an upper end portion 151, a lower end portion 154, and a first middle portion 152. The upper end portion 151 is positioned at the first opening part 13a of the through-hole 13. The lower end portion 154 contacts the first internal bottom surface 11c-1. The first middle portion 152 is positioned between the upper end portion 151 and the lower end portion 154. An outline of the first portion 15a in a vertical section may include a gentle curve forming a gradually increasing width from the upper end portion 151 to the first middle portion 152, and a gradually reducing width downwardly from the first middle portion 152. When the seal body 15 has a cylindrical shape, the above-described width may be rephrased as a diameter.

The first internal bottom surface 11c-1 may have a recessed shape, and a tip end of the first portion 15a may fit into the recessed portion.

The bulge seen in the outline of the first portion 15a, and the recess of the first internal bottom surface 11c-1 may be shapes that are formed by the seal body 15 being pressed downward when the seal body 15 plugs the through-hole 13.

As illustrated in FIG. 6B, in the Embodiments 4 to 6, the same as and/or similarly to Embodiments 1 to 3, the first portion 15a of the seal body 15 may include the upper end portion 151, the lower end portion 154, and the first middle portion 152. The same as and/or similarly to Embodiments 1 to 3, an outline of the first portion 15a in a vertical section may include a gentle curve forming a gradually increasing width from the upper end portion 151 to the first middle portion 152, and a gradually reducing width downwardly from the first middle portion. When the seal body 15 has a cylindrical shape, the above-described width may be rephrased as a diameter.

In Embodiments 4 to 6, the first portion 15a may further include a second middle portion 153 between the first middle portion 152 and the lower end portion 154. The outline of the first portion 15a in the vertical section may include a bend 153a having a minimum width at the second middle portion 153. The second middle portion 153 with the minimum width may be referred to as a narrowed part.

In Embodiments 4 to 6, the first internal bottom surface 11c-1 has a planar shape, and the first portion 15a of the seal body 15 may have a gradually increasing width from the second middle portion 153 to the lower end portion 154.

The bulge seen in the outline of the first portion 15a and the bend (that is, the shape of the narrowed part) of the second middle portion 153 may be shapes that are formed by the seal body 15 being applied with pressure when the seal body 15 plugs the through-hole 13, and are caused by the first internal bottom surface 11c-1 having a large Young's modulus.

The shape of the seal body 15 illustrated in FIGs. 6A and 6B allows the through-hole 13 to be plugged to seal the internal space 111 while reducing deformation around the second opening part 13b of the through-hole 13. Even when internal pressure of the internal space 111 increases or decreases, sealing of the internal space 111 can easily be maintained.

(Embodiment 7)

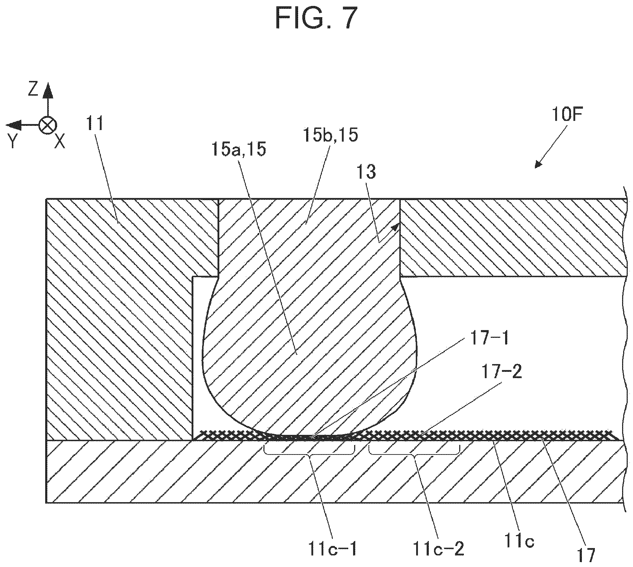

FIG. 7 is a vertical sectional view illustrating a heat dissipation substrate in Embodiment 7. In Embodiment 7, a heat dissipation substrate 10F may be the same as and/or similar to those in Embodiments 1 to 6, except for difference in a configuration related to the void structure 17. Although FIG. 7 illustrates an example in which a material for the bottom portion of the housing 11 is different from a material for another portion, the entire housing 11 may be made of the same material.

The void structure 17 may be integrated with the internal bottom surface 11c of the housing 11, thus being a part of the internal bottom surface 11c. The internal bottom surface 11c may include the first internal bottom surface 11c-1 that contacts the first portion 15a of the seal body 15 and a second internal bottom surface 11c-2 adjacent to the first internal bottom surface 11c-1. The void structure 17 may include a first void structure 17-1 positioned at the first internal bottom surface 11c-1 and a second void structure 17-2 positioned at the second internal bottom surface 11c-2. The second internal bottom surface 11c-2 may mean a portion of the internal bottom surface 11c around the first internal bottom surface 11c-1.

By the first void structure 17-1 being positioned at the first internal bottom surface 11c-1, when, in the sealing process, the tip end of the seal body 15 contacts the first internal bottom surface 11c-1 and then the seal body 15 is further pushed in, friction force acts on the tip end of the seal body 15. Therefore, the seal body 15 can be less likely to bend unexpectedly due to sliding of the tip end of the seal body 15 on the first internal bottom surface 11c-1. Accordingly, the sealing process can be accomplished more stably, and the heat dissipation substrate 10F can have an improved yield.

A porosity of the first void structure 17-1 may be smaller than a porosity of the second void structure 17-2. The porosity means a volume occupied by voids per unit volume of the void structure 17. The difference in the porosity means improvement in a degree of coupling between the tip end of seal body 15 and the first internal bottom surface 11c-1 by the first void structure 17-1. Therefore, the above-described configuration provides an anchoring effect by the first void structure 17-1, and can further reduce displacement of the seal body 15 in a direction to come out from the through-hole 13.

(Embodiment 8)

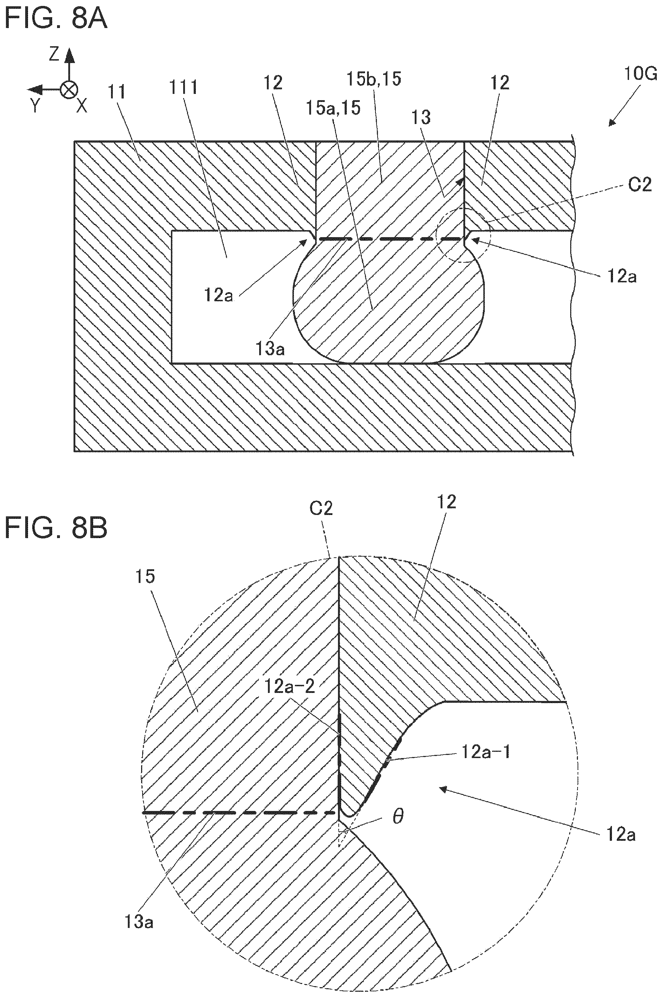

FIG. 8A is a vertical sectional view illustrating a heat dissipation substrate in Embodiment 8. FIG. 8B is an enlarged view illustrating a portion C2 in FIG. 8A. In Embodiment 8, a heat dissipation substrate 10G may be the same as and/or similar to those in Embodiments 1 to 7, except for difference in a part of the internal wall part 12 surrounding the through-hole 13.

The internal wall part 12 surrounding the through-hole 13 may include a protrusion 12a protruding toward the internal space 111. The protrusion 12a may be in contact with the seal body 15. The protrusion 12a may be positioned at the boundary between the through-hole 13 and the internal space 111 (that is, at the first opening part 13a), and a tip end of the protrusion 12a may have an acute angle. The tip end of the protrusion 12a having an acute angle means that a corner portion of the tip end of the protrusion 12a has an acute angle in a vertical section. Here, the acute angle means an acute angle while roundness at a microscopic level is ignored. That is, as illustrated in FIG. 8B, the acute angle may mean that an angle θ formed between an extended line of a first side 12a-1 and an extended line of a second side 12a-2 is an acute angle. The extended line of the first side 12a-1 and the extended line of the second side 12a-2 are adjacent to one another while sandwiching the tip-end portion of the protrusion 12a therebetween.

For example, the protrusion 12a can be formed in the following manner. That is, in formation of the through-hole 13 in the housing 11, a burr is left at the opening at the internal space 111 side (that is, at the first opening part 13a). Then, the burr is inclined in such a manner that an end of the burr faces a center of the opening. The protrusion 12a can be formed by execution of the sealing process with the seal body 15 in this state.

Providing of the protrusion 12a can make the first opening part 13a of the through-hole 13 less likely to expand even when internal pressure of the internal space 111 increases. Therefore, in the through-hole 13, the seal body 15 can be less likely to be displaced outwardly, and airtightness between the internal wall part 12 of the through-hole 13 and the seal body 15 can improve.

(Element Mounting Example)

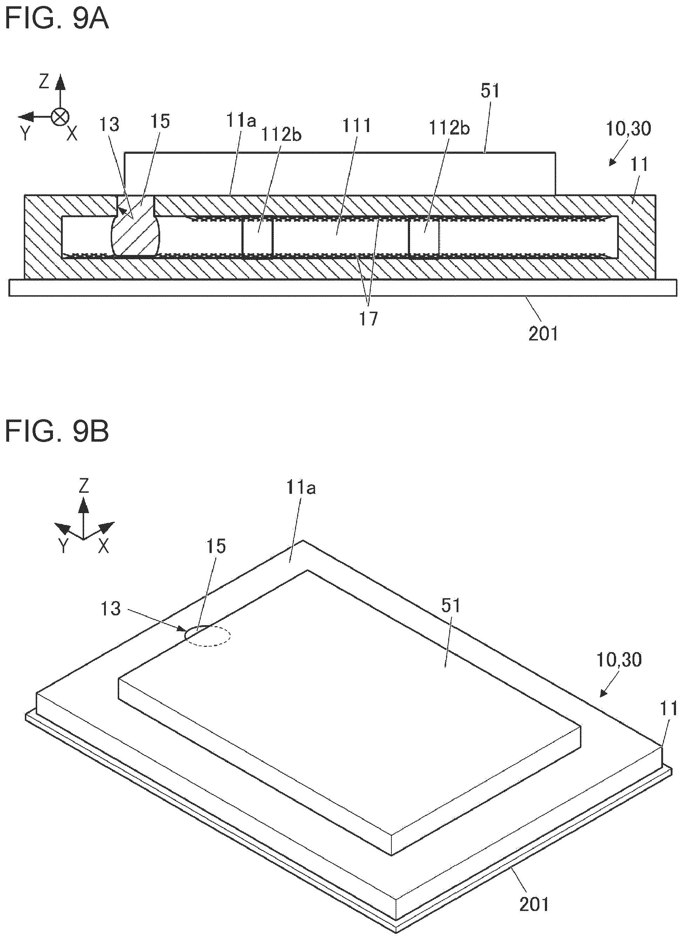

FIGs. 9A and 9B are respectively a vertical sectional view and a perspective view illustrating an example in which an element is mounted on a heat dissipation substrate in an embodiment. An element 51 that generates heat is mounted on the heat dissipation substrate 10 and the vapor chamber 30 in Embodiment 1, and the heat dissipation substrate 10 and the vapor chamber 30 dissipate heat of the element 51. The element 51 may be a power element, such as a power semiconductor, in which large current flows or may be various other elements. The element 51 may be mounted on a module board 201 with the heat dissipation substrate 10 and the vapor chamber 30 interposed therebetween.

As illustrated in FIGs. 9A and 9B, the element 51 may be mounted in such a manner as to overlap a region of the first surface 11a where the through-hole 13 and the seal body 15 are positioned, or may be mounted outside of this region. Alternatively, a terminal of the element 51 may be bonded to the above-described region of the first surface 11a. The terminal may be bonded via a conductive bonding material or may be bonded by ultrasonic bonding or the like.

In Embodiment 1, the heat dissipation substrate 10 and the vapor chamber 30 can improve flatness around the seal part of the housing 11 on the external surface as described above. Therefore, even when the element 51 is mounted on the first surface 11a as illustrated in FIGs. 9A and 9B, the seal part can be less likely to be an obstacle for mounting of the element 51.

As compared with another configuration in which a passage for introducing liquid-phase fluid into the internal space 111 and depressurizing the internal space 111 is positioned at a side of the heat dissipation substrate 10, the heat dissipation substrate 10 and the vapor chamber 30 in Embodiment 1 can improve flatness at the side in the same and/or similar manner. Therefore, when multiple heat dissipation substrates 10 and vapor chambers 30 are mounted side by side on a single module board 201, a degree of aggregation of the heat dissipation substrates 10 and vapor chambers 30 can improve, because, for example, the adjacent heat dissipation substrates 10 and vapor chambers 30 can be positioned close to one another. The heat dissipation substrate 10 and the vapor chamber 30 can also have an improved degree of freedom in placement.

The heat dissipation substrate 10 in FIGs. 9A and 9B may be replaced by any of the heat dissipation substrates 10A to 10G in Embodiments 2 to 8, and the replacement configuration can also achieve an effect as described above.

Each embodiment of the present disclosure has been described above. However, the heat dissipation substrate and the vapor chamber of the present disclosure are not limited to those in the embodiments described above. Details described in the embodiments are changeable as appropriate without departing from a spirt of the present invention.

Below, an embodiment of the present disclosure is described. In an embodiment, (1) a heat dissipation substrate includes: a housing with an internal space; and a seal body configured to seal the internal space, wherein the housing includes a through-hole and an internal bottom surface, the through-hole communicating with the internal space, the seal body includes a first portion and a second portion, the first portion being positioned at the internal space, the second portion being positioned at the thorough-hole, the first portion contacts the internal bottom surface, and a maximum width of the first portion is larger than a minimum width of the through-hole in a vertical section.

(2) In the heat dissipation substrate of (1), the through-hole includes a first opening part positioned at a boundary to the internal space, and the maximum width of the first portion is larger than a width of the first opening part in the vertical section.

(3) In the heat dissipation substrate of (1) or (2), the housing includes a first surface in a planar shape, and one end of the through-hole is positioned at the first surface.

(4) In the heat dissipation substrate of any one of (1) to (3), the housing includes an internal wall part surrounding the through-hole, a crystal grain size of the seal body is φ1, a crystal grain size of the internal wall part is φ2, and $\varphi1 > 0.8 \times \varphi2$ is satisfied.

(5) In the heat dissipation substrate of (4), the internal wall part and the seal body are made of metals with a same main constituent.

(6) In the heat dissipation substrate of any one of (1) to (5), the internal bottom surface includes a first internal bottom surface configured to contact the seal body, the housing includes an internal wall part surrounding the through-hole, a Young's modulus of the first internal bottom surface is higher than a Young's modulus of the seal body, and the Young's modulus of the first internal bottom surface is higher than a Young's modulus of the internal wall part.

(7) The heat dissipation substrate of any one of (1) to (6) further includes a void structure with a void, wherein the void structure is positioned at the internal bottom surface, the internal bottom surface includes a first internal bottom surface and a second internal bottom surface, the first internal bottom surface contacting the seal body, the second internal bottom surface being adjacent to the first internal bottom surface, the void structure includes a first void structure and a second void structure, the first void structure being positioned at the first internal bottom surface, the second void structure being positioned at the second internal bottom surface, and a porosity of the first void structure is smaller than a porosity of the second void structure.

(8) In the heat dissipation substrate of any one of (1) to (7), the housing includes an internal wall part surrounding the through-hole, the internal wall part includes a protrusion protruding toward the internal space, and the protrusion is in contact with the seal body.

(9) In the heat dissipation substrate of any one of (1) to (8), the through-hole includes a first opening part positioned at a boundary to the internal space, the first portion of the seal body includes an upper end portion, a lower end portion, and a first middle portion, the upper end portion being positioned at the first opening part, the lower end portion contacting the internal bottom surface, the first middle portion being positioned between the upper end portion and the lower end portion, an outline of the first portion in the vertical section includes a curve forming a gradually increasing width of the first portion from the upper end portion to the first middle portion and a gradually reducing width of the first portion downwardly from the first middle portion.

(10) In the heat dissipation substrate of (9), the first portion of the seal body includes a second middle portion between the first middle portion and the lower end portion, and the outline of the first portion in the vertical section includes a bend forming a minimum width of the first portion at the second middle portion.

In an embodiment, (11) a vapor chamber includes the heat dissipation substrate of any one of (1) to (10), and liquid-phase fluid positioned at the internal space.

INDUSTRIAL APPLICABILITY

The present disclosure is applicable to a heat dissipation substrate and a vapor chamber.

REFERENCE SIGNS

10, 10A to 10G heat dissipation substrate
11 housing
11a first surface
11A base part
11B upper structure
11D member
11E topmost layer
11c internal bottom surface
11c-1 first internal bottom surface
11c-2 second internal bottom surface
12 internal wall part
12a protrusion
13 through-hole
13a first opening part
13b second opening part
15 seal body
15a first portion
15b second portion
17 void structure
17-1 first void structure
17-2 second void structure
51 element
111 internal space
111a passage
112 support body
115 side wall
151 upper end portion
152 first middle portion
153 second middle portion
153a bend
154 lower end portion
201 module board
W15max maximum width
W13min minimum width
W13a width

**Claims**

1.  A heat dissipation substrate comprising:

    a housing with an internal space; and
    a seal body configured to seal the internal space, wherein
    the housing comprises a through-hole and an internal bottom surface, the through-hole communicating with the internal space,
    the seal body comprises a first portion and a second portion, the first portion being positioned at the internal space, the second portion being positioned at the thorough-hole,
    the first portion contacts the internal bottom surface, and
    a maximum width of the first portion is larger than a minimum width of the through-hole in a vertical section.

2. The heat dissipation substrate according to claim 1, wherein the through-hole comprises a first opening part positioned at a boundary to the internal space, and
the maximum width of the first portion is larger than a width of the first opening part in the vertical section.

3. The heat dissipation substrate according to claim 1, wherein the housing comprises a first surface in a planar shape, and
one end of the through-hole is positioned at the first surface.

4. The heat dissipation substrate according to claim 1, wherein the housing comprises an internal wall part surrounding the through-hole,

a crystal grain size of the seal body is φ1,
a crystal grain size of the internal wall part is φ2, and
φ1 > 0.8 × φ2 is satisfied.

5. The heat dissipation substrate according to claim 4, wherein the internal wall part and the seal body are made of metals with a same main constituent.

6. The heat dissipation substrate according to claim 1, wherein the internal bottom surface comprises a first internal bottom surface configured to contact the seal body,

the housing comprises an internal wall part surrounding the through-hole,
a Young's modulus of the first internal bottom surface is higher than a Young's modulus of the seal body, and
the Young's modulus of the first internal bottom surface is higher than a Young's modulus of the internal wall part.

7. The heat dissipation substrate according to claim 1, further comprising a void structure with a void, wherein

the void structure is positioned at the internal bottom surface,
the internal bottom surface comprises a first internal bottom surface and a second internal bottom surface, the first internal bottom surface contacting the seal body, the second internal bottom surface being adjacent to the first internal bottom surface,
the void structure comprises a first void structure and a second void structure, the first void structure being positioned at the first internal bottom surface, the second void structure being positioned at the second internal bottom surface, and
a porosity of the first void structure is smaller than a porosity of the second void structure.

8. The heat dissipation substrate according to claim 1, wherein the housing comprises an internal wall part surrounding the through-hole,

the internal wall part comprises a protrusion protruding toward the internal space, and
the protrusion is in contact with the seal body.

9. The heat dissipation substrate according to claim 1, wherein the through-hole comprises a first opening part positioned at a boundary to the internal space,

the first portion of the seal body comprises an upper end portion, a lower end portion, and a first middle portion, the upper end portion being positioned at the first opening part, the lower end portion contacting the internal bottom surface, the first middle portion being positioned between the upper end portion and the lower end portion,
an outline of the first portion in the vertical section comprises a curve forming a gradually increasing width of the first portion from the upper end portion to the first middle portion and a gradually reducing width of the first portion downwardly from the first middle portion.

10. The heat dissipation substrate according to claim 9, wherein the first portion of the seal body comprises a second middle portion between the first middle portion and the lower end portion, and
the outline of the first portion in the vertical section comprises a bend forming a minimum width of the first portion at the second middle portion.

11. A vapor chamber comprising:

the heat dissipation substrate according to claim 1; and
liquid-phase fluid positioned at the internal space.

# FIG. 1A

10,30

15b,15
13
112b
111
112b
11b
11a
11

15a,15

17

11c

# FIG. 1B

10,30

15

L1
13
112b
111
112b
11b
11a
11

L2

11c-1

17

11c

# FIG. 1C

10,30

15
11
13
111
11a

Z

Y X

FIG. 2A

FIG. 2B

## FIG. 3A

## FIG. 3B

FIG. 4A

FIG. 4B

CRYSTAL GRAIN SIZE Φ2      CRYSTAL GRAIN SIZE Φ1

FIG. 5A

FIG. 5B

FIG. 5C

FIG. 6A

10,10A,10B

FIG. 6B

10C,10D,10E

# FIG. 7

FIG. 8A

FIG. 8B

FIG. 9A

FIG. 9B

## INTERNATIONAL SEARCH REPORT

| International application No. |
|---|
| **PCT/JP2023/026555** |

**A. CLASSIFICATION OF SUBJECT MATTER**

*F28D 15/02*(2006.01)i; *B21D 39/00*(2006.01)i; *H01L 23/427*(2006.01)i; *H05K 7/20*(2006.01)i
FI: F28D15/02 106F; B21D39/00 B; F28D15/02 101H; F28D15/02 102A; F28D15/02 102H; H01L23/46 B; H05K7/20 R

According to International Patent Classification (IPC) or to both national classification and IPC

**B. FIELDS SEARCHED**

Minimum documentation searched (classification system followed by classification symbols)

F28D15/02; B21D39/00; B23P11/02; B23P19/02; H01L23/427; H05K7/20

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | CN 106225533 A (SUZHOU FORCECON ELECTRIC CO., LTD.) 14 December 2016 (2016-12-14) <br> paragraphs [0012]-[0018], fig. 1-7 | 1-3, 8, 11 |
| A | | 4-7, 9-10 |
| Y | JP 2007-315745 A (FUCHIGAMI MICRO KK) 06 December 2007 (2007-12-06) <br> paragraphs [0075], [0159]-[0178], fig. 18-22 | 1-3, 8, 11 |
| A | Microfilm of the specification and drawings annexed to the request of Japanese Utility Model Application No. 76831/1989 (Laid-open No. 21679/1991) (SUMITOMO LIGHT METAL INDUSTRIES, LTD.) 05 March 1991 (1991-03-05), entire text, all drawings | 1-11 |
| A | JP 4035155 B1 (FUCHIGAMI MICRO CO., LTD.) 16 January 2008 (2008-01-16) <br> entire text, all drawings | 1-11 |
| A | JP 53-106961 A (NGK SPARK PLUG CO., LTD.) 18 September 1978 (1978-09-18) <br> entire text, all drawings | 1-11 |
| A | JP 58-85555 A (NGK SPARK PLUG CO., LTD.) 21 May 1983 (1983-05-21) <br> entire text, all drawings | 1-11 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **03 October 2023** | **10 October 2023** |

| Name and mailing address of the ISA/JP | Authorized officer |
|---|---|
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

## INTERNATIONAL SEARCH REPORT

| International application No. |
| --- |
| **PCT/JP2023/026555** |

**C. DOCUMENTS CONSIDERED TO BE RELEVANT**

| Category* | Citation of document, with indication, where appropriate, of the relevant passages | Relevant to claim No. |
| --- | --- | --- |
| A | WO 2021/182644 A1 (FURUKAWA ELECTRIC CO., LTD.) 16 September 2021 (2021-09-16)<br>  entire text, all drawings | 1-11 |

Form PCT/ISA/210 (second sheet) (January 2015)

## INTERNATIONAL SEARCH REPORT
### Information on patent family members

| International application No. |
| --- |
| **PCT/JP2023/026555** |

| Patent document cited in search report | | | Publication date (day/month/year) | Patent family member(s) | | | Publication date (day/month/year) |
| --- | --- | --- | --- | --- | --- | --- | --- |
| CN | 106225533 | A | 14 December 2016 | (Family: none) | | | |
| JP | 2007-315745 | A | 06 December 2007 | US | 2008/0135214 | A1 | |
| | | | | paragraphs [0132], [0222]-[0241], fig. 18-22 | | | |
| | | | | WO | 2007/026833 | A1 | |
| | | | | EP | 1930682 | A1 | |
| | | | | CN | 101133295 | A | |
| | | | | CA | 2614471 | A1 | |
| | | | | KR | 10-2008-0048438 | A | |
| JP | 3-21679 | U1 | 05 March 1991 | (Family: none) | | | |
| JP | 4035155 | B1 | 16 January 2008 | US | 2021/0310745 | A1 | |
| | | | | entire text, all drawings | | | |
| | | | | WO | 2008/012960 | A1 | |
| | | | | EP | 2051032 | A1 | |
| | | | | CN | 101421577 | A | |
| | | | | KR | 10-2009-0045146 | A | |
| JP | 53-106961 | A | 18 September 1978 | (Family: none) | | | |
| JP | 58-85555 | A | 21 May 1983 | (Family: none) | | | |
| WO | 2021/182644 | A1 | 16 September 2021 | (Family: none) | | | |

Form PCT/ISA/210 (patent family annex) (January 2015)

**EP 4 560 243 A1**

**Patent documents cited in the description**

- WO 2008012960 A